# EUROPÄISCHE PATENTSCHRIFT

(11) **EP 1 819 793 B1**
(45) Veröffentlichungstag und Bekanntmachung des Hinweises auf die Patenterteilung: **14.01.2009**
(21) Anmeldenummer: 05808149.8
(22) Anmeldetag: 11.11.2005
(51) Int. Cl.: C09J 7/00, C09J 109/02

(54) **HITZEAKTIVIERBARES KLEBEBAND AUF BASIS CARBOXYLIERTER NITRILKAUTSCHUKE FÜR DIE VERKLEBUNG VON ELEKTRONISCHEN BAUTEILEN UND LEITERBAHNEN**
ADHESIVE STRIP THAT CAN BE ACTIVATED BY HEAT AND IS BASED ON CARBOXYLATED NITRILE RUBBER FOR STICKING TOGETHER COMPONENTS AND STRIP CONDUCTORS
BANDE ADHESIVE ACTIVABLE A LA CHALEUR, A BASE DE CAOUTCHOUC NITRILE CARBOXYLE, DESTINEE AU COLLAGE DE COMPOSANTS ELECTRONIQUES ET DE PISTES CONDUCTRICES

(30) Priorität: 29.11.2004 DE 102004057650
(43) Veröffentlichungstag der Anmeldung: 22.08.2007
(73) Patentinhaber: tesa AG, 20253 Hamburg (DE)
(72) Erfinder: KRAWINKEL, Thorsten, 22457 Hamburg (DE); RING, Christian, 20259 Hamburg (DE)
(86) Internationale Anmeldenummer: PCT/EP2005/055910
(87) Internationale Veröffentlichungsnummer: WO 2006/058827

(56) Entgegenhaltungen:
- PATENT ABSTRACTS OF JAPAN Bd. 1999, Nr. 12, 29. Oktober 1999 (1999-10-29) & JP 11 181380 A (MITSUI CHEM INC), 6. Juli 1999 (1999-07-06) in der Anmeldung erwähnt
- PATENT ABSTRACTS OF JAPAN Bd. 018, Nr. 082 (C-1164), 10. Februar 1994 (1994-02-10) & JP 05 287255 A (MITSUI PETROCHEM IND LTD), 2. November 1993 (1993-11-02) in der Anmeldung erwähnt
- PATENT ABSTRACTS OF JAPAN Bd. 2000, Nr. 21, 3. August 2001 (2001-08-03) & JP 2001 107001 A (HITACHI CABLE LTD; HITACHI LTD), 17. April 2001 (2001-04-17)

## Beschreibung

Die Erfindung betrifft eine hitzeaktivierbare Klebmasse mit geringem Fließvermögen bei hohen Temperaturen zur Verklebung von flexiblen gedruckten Leiterbahnen (Flexible Printed Circuit Boards, FPCBs).

Flexible Printed Circuit Boards werden heutzutage in einer Vielzahl von elektronischen Geräten wie Handys, Radios, Computern, Druckern und vielen anderen eingesetzt. Sie sind aufgebaut aus Schichten von Kupfer und einem hochschmelzenden widerstandsfähigen Thermoplasten meistens Polyimid, seltener Polyester. Für die Herstellung dieser FPCBs werden häufig Klebebänder mit besonders hohen Ansprüchen eingesetzt. Zum einen werden zur Herstellung der FPCBs die Kupferfolien mit den Polyimidfolien verklebt, zum anderen werden auch einzelne FPCBs miteinander verklebt, in diesem Fall findet eine Verklebung von Polyimid auf Polyimid statt. Daneben werden die FPCBs auch auf andere Substrate geklebt.

An die Klebebänder, die für diese Verklebungen eingesetzt werden, werden sehr hohe Ansprüche gestellt. Da sehr hohe Verklebungsleistungen erreicht werden müssen, werden im Allgemeinen hitzeaktivierbare Klebebänder eingesetzt, die bei hohen Temperaturen verarbeitet werden. Diese Klebebänder dürfen während dieser hohen Temperaturbelastung bei der Verklebung der FPCBs, die häufig bei Temperaturen um 200 °C stattfindet, keine flüchtigen Bestandteile abgeben. Um eine hohe Kohäsion zu erreichen, sollten die Klebebänder während dieser Temperaturbelastung vernetzen. Hohe Drücke während des Verklebungsprozesses machen es nötig, dass die Klebebänder bei hohen Temperaturen nur eine geringe Fließfähigkeit besitzen. Dieses wird durch hohe Viskosität des unvernetzten Klebebandes oder durch eine schnelle Vernetzung erreicht. Zudem müssen die Klebebänder noch lötbadbeständig sein, das heißt, für eine kurze Zeit eine Temperaturbelastung von 288 °C überstehen.

Aus diesem Grund ist der Einsatz von reinen Thermoplasten nicht sinnvoll, obwohl diese sehr leicht aufschmelzen und für eine gute Benetzung der zu verklebenden Substrate sorgen und zu einer sehr schnellen Verklebung innerhalb von wenigen Sekunden führen. Andererseits sind diese bei hohen Temperaturen so weich, dass sie bei Verklebung unter Druck zum Herausquellen aus der Klebfuge neigen. Damit ist auch keine Lötbadbeständigkeit gegeben.

Üblicherweise werden für vernetzbare Klebebänder Epoxidharze oder Phenolharze eingesetzt, die mit bestimmten Härtern zu polymeren Netzwerken reagieren. In diesem speziellen Fall sind die Phenolharze nicht einsetzbar, da sie bei der Vernetzung Abspaltprodukte erzeugen, die freigesetzt werden und während der Aushärtung oder spätestens im Lötbad zu einer Blasenbildung führen.

Epoxidharze werden hauptsächlich in der Konstruktionsverklebung eingesetzt und ergeben nach der Aushärtung mit entsprechenden Vernetzern sehr spröde Klebmassen, die zwar hohe Klebfestigkeiten erreichen, aber kaum flexibel sind.

Eine Steigerung der Flexibilität ist für den Einsatz in FPCBs unumgänglich. Zum einen soll die Verklebung mit Hilfe eines Klebebandes geschehen, das idealerweise auf eine Rolle gewickelt ist, zum anderen handelt es sich um flexible Leiterbahnen, die auch gebogen werden müssen, gut zu erkennen am Beispiel der Leiterbahnen in einem Laptop, bei dem der aufklappbare Bildschirm über FPCBs mit den weiteren Schaltungen verbunden ist.

Eine Flexibilisierung dieser Epoxidharzkleber ist auf zwei Arten möglich. Zum einen existieren mit Elastomerketten flexibilisierte Epoxidharze, die aber durch die sehr kurzen Elastomerketten nur eine begrenzte Flexibilisierung erfahren. Die andere Möglichkeit ist, die Flexibilisierung durch die Zugabe von Elastomeren zu erreichen, die der Klebmasse zugegeben werden. Diese Variante hat den Nachteil, dass die Elastomere chemisch nicht vernetzt werden, wodurch nur solche Elastomere zum Einsatz kommen können, die bei hohen Temperaturen immer noch eine hohe Viskosität aufweisen.

Da die Klebebänder meistens aus Lösung hergestellt werden, ist es häufig schwierig, Elastomere zu finden, die langkettig genug sind, um bei hohen Temperaturen nicht zu fließen, andererseits aber noch in konventionellen Lösungsmitteln löslich sind.

Eine Herstellung über einen Hotmelt-Prozess ist bei vernetzenden Systemen nur sehr schwierig möglich, da eine frühzeitige Vernetzung während des Herstellprozesses vermieden werden muss.

Klebmassen auf Basis von säuremodifizierten Acrylnitril-Butadien-Copolymeren (Nitrilkautschuken) und Epoxidharzen sind bekannt aus JP 2001 107 001 A JP 05 287 255 A, JP 11 061 073 A, JP 03 028 285 A und JP 61 076 579 A. In allen diesen Fällen werden neben den carboxylierten Nitrilkautschuken und den Epoxidharzen noch Härter für die Epoxidharze zugegeben, bevorzugt als Amine.
In JP 11 181 380 A ist zwar der Einsatz eines Härters nicht ausdrücklich genannt, der Anteil von Epoxidharz liegt aber so hoch, das die Epoxidgruppen in einem deutlichen Überschuss gegenüber den Säuregruppen des modifizierten Nitrilkautschuks liegen, so dass eine vollständige Vernetzung nur über einen zusätzlichen Härter erfolgen kann. Zudem ist durch den hohen Epoxidharzanteil das Klebeband sehr hart und nicht so flexibel wie gewünscht.

Aufgabe der Erfindung ist es somit, ein Klebeband bereitzustellen, dass hitzeaktivierbar ist, in der Hitze vernetzt, in der Hitze gut auf das zu verklebende Substrat auffließt, gute Haftung auf Polyimid zeigt und im unvernetzten Zustand löslich in organischen Lösungsmitteln ist.

Gelöst wird diese Aufgabe überraschend durch ein Klebeband, wie es in dem Hauptanspruch näher gekennzeichnet ist. Gegenstand der Unteransprüche sind vorteilhafte Weiterentwicklungen des Erfindungsgegenstandes.

Demgemäß ist Gegenstand der Erfindung ein hitzeaktivierbares Klebeband für die Herstellung und Weiterverarbeitung von flexiblen Leiterbahnen mit einer Klebmasse bestehend aus zumindest
a) einem säure- oder säureanhydridmodifizierten Acrylnitril-Butadien-Copolymer und
b) einem Epoxidharz,
wobei das Gewichtsverhältnis der beiden Komponenten a/b größer als 1,5 ist und wobei kein zusätzlicher nicht polymerer Härter eingesetzt wird.

Der allgemeine Ausdruck "Klebeband" umfasst im Sinne dieser Erfindung alle flächigen Gebilde wie in zwei Dimensionen ausgedehnte Folien oder Folienabschnitte, Bänder mit ausgedehnter Länge und begrenzter Breite, Bandabschnitte, Stanzlinge und dergleichen.

Vorteil der erfindungsgemäßen Klebmassen ist, dass das Elastomer tatsächlich chemisch mit dem Harz vernetzt, eine Zugabe eines Härters für das Epoxidharz ist nicht notwendig, da das Elastomer selbst als Härter wirkt.
Dadurch wird das Elastomer mit in das Netzwerk eingebaut, was zu einer deutlich erhöhten Festigkeit der vernetzten Klebmasse führt gegenüber Klebmassen, bei denen nur das Epoxidharz mit einem Härter vernetzt wird.

Als Nitrilkautschuke können insbesondere in erfindungsgemäßen Klebmassen alle Acrylnitril-Butadien-Copolymere zum Einsatz kommen mit einem Acrylnitrilgehalt von 15 bis 50 Gew.-%. Ebenso sind auch Copolymere aus Acrylnitril, Butadien und Isopren einsetzbar. Dabei ist der Anteil von 1,2-verknüpftem Butadien variabel. Die vorgenannten Polymere können zu einem unterschiedlichen Grad hydriert sein auch vollständig hydrierte Polymere mit einem Doppelbindungsanteil von unter 1 % sind nutzbar.

Alle diese Nitrilkautschuke sind zu einem gewissen Grad carboxyliert, bevorzugt liegt der Anteil der Säuregruppen bei 2 bis 15 Gew.-%. Kommerziell sind solche Systeme zum Beispiel unter dem Namen Nipol 1072 oder Nipol NX 775 der Firma Zeon erhältlich. Hydrierte carboxylierte Nitrilkautschuke sind unter dem Namen Therban XT VP KA 8889 von der Firma Lanxess kommerzialisiert.

Als Epoxidharze werden üblicherweise sowohl monomere als auch oligomere Verbindungen mit mehr als einer Epoxidgruppe pro Molekül verstanden. Dieses können Reaktionsprodukte von Glycidestern oder Epichlorhydrin mit Bisphenol A oder Bisphenol F oder Mischungen aus diesen beiden sein. Einsetzbar sind ebenfalls Epoxidnovolakharze gewonnen durch Reaktion von Epichlorhydrin mit dem Reaktionsprodukt aus Phenolen und Formaldehyd. Auch monomere Verbindungen mit mehreren Epoxidendgruppen, die als Verdünner für Epoxidharze eingesetzt werden, sind verwendbar. Ebenfalls sind elastisch modifizierte Epoxidharze einsetzbar.
Beispiele von Epoxidharzen sind Araldite^{TM} 6010, CY-281^{TM} , ECN^{TM} 1273, ECN^{TM} 1280, MY 720, RD-2 von Ciba Geigy, DER^{TM} 331, 732, 736, DEN^{TM} 432 von Dow Chemicals, Epon^{TM} 812, 825, 826, 828, 830 etc. von Shell Chemicals, HPT^{TM} 1071, 1079 ebenfalls von Shell Chemicals, Bakelite^{TM} EPR 161, 166, 172, 191, 194 etc. der Bakelite AG.

Kommerzielle aliphatische Epoxidharze sind zum Beispiel Vinylcyclohexandioxide wie ERL-4206, 4221, 4201, 4289 oder 0400 von Union Carbide Corp.

Elastifizierte Epoxidharze sind erhältlich von der Firma Noveon unter dem Namen Hycar.

Epoxidverdünner, monomere Verbindungen mit mehreren Epoxidgruppen sind zum Beispiel Bakelite^{TM} EPD KR, EPD Z8, EPD HD, EPD WF, etc. der Bakelite AG oder Polypox^{TM} R 9, R12, R 15, R 19, R 20 etc. der Firma UCCP.

Weiter vorzugsweise enthält das Klebeband mehr als ein Epoxidharz.

Neben den schon genannten säure- oder säureanhydridmodifizierten Nitrilkautschuken können auch noch weitere Elastomere eingesetzt werden. Neben weiteren säure- oder säureanhydridmodifizierten Elastomeren können auch nicht modifizierte Elastomere zum Einsatz kommen wie zum Beispiel Polyvinylalkohol, Polyvinylacetat, Styrolblockcopolymere, Polyvinylformal, Polyvinylbutyral oder lösliche Polyester.
Auch Copolymere mit Maleinsäureanhydrid wie zum Beispiel ein Copolymer aus Polyvinylmethylether und Maleinsäureanhydrid, zum Beispiel zu beziehen unter dem Namen Gantrez^{TM}, vertrieben von der Firma ISP, sind einsetzbar.

Durch die chemische Vernetzung der Harze mit den Elastomeren werden sehr große Festigkeiten innerhalb des Klebefilms erreicht. Aber auch die Verklebungsfestigkeiten zum Polyimid sind ausgesprochen hoch.

Um die Adhäsion zu erhöhen, ist auch der Zusatz von mit dem Elastomer verträglichen Klebharzen möglich.

Als Klebrigmacher können in erfindungsgemäßen Haftklebemassen zum Beispiel nicht hydrierte, partiell- oder vollständig hydrierte Harze auf Basis von Kolophonium und Kolophoniumderivaten, hydrierte Polymerisate des Dicyclopentadiens, nicht hydrierte, partiell, selektiv oder vollständig hydrierte Kohlenwasserstoffharze auf Basis von C₅-, C₅/C₉-oder C₉-Monomerströmen, Polyterpenharze auf Basis von α-Pinen und/oder ß-Pinen und/oder δ-Limonen, hydrierte Polymerisate von bevorzugt reinen C₈- und C₉-Aromaten eingesetzt werden. Vorgenannte Klebharze können sowohl allein als auch im Gemisch eingesetzt werden.

Als weitere Additive können typischerweise genutzt werden:
- primäre Antioxidanzien, wie zum Beispiel sterisch gehinderte Phenole
- sekundäre Antioxidanzien, wie zum Beispiel Phosphite oder Thioether
- Prozessstabilisatoren, wie zum Beispiel C-Radikalfänger
- Lichtschutzmittel, wie zum Beispiel UV-Absorber oder sterisch gehinderte Amine
- Verarbeitungshilfsmittel
- Füllstoffe, wie zum Beispiel Siliziumdioxid, Glas (gemahlen oder in Form von Kugeln), Aluminiumoxide, Zinkoxide, Calciumcarbonate, Titandioxide, Ruße, Metallpulver, etc.
- Farbpigmente und Farbstoffe sowie optische Aufheller

Durch den Einsatz von Weichmachern kann die Elastizität der vernetzten Klebmasse erhöht werden. Als Weichmacher können dabei zum Beispiel niedermolekulare Polyisoprene, Polybutadiene, Polyisobutylene oder Polyethylenglykole und Polypropylenglykole eingesetzt werden.

Da die eingesetzten Nitrilkautschuke auch bei hohen Temperaturen keine zu niedrige Viskosität besitzen, kommt es während des Verklebens und Heißpressens nicht zum Austritt der Klebmasse aus der Klebfuge. Während dieses Vorgangs vernetzen die Epoxidharze mit den Elastomeren, es ergibt sich ein dreidimensionales Netzwerk.

Durch die Zugabe von so genannten Beschleunigern kann die Reaktionsgeschwindigkeit weiter erhöht werden.
Beschleuniger können zum Beispiel sein:
- tertiäre Amine, wie Benzyldimethylamin, Dimethylaminomethylphenol, Tris(dimethylaminomethyl)phenol
- Bortrihalogenid-Amin-Komplexe
- substituierte Imidazole
- Triphenylphosphin

Idealerweise werden die säure- beziehungsweise säureanhydridmodifizierten Elastomere und Epoxidharze in einem Mengenverhältnis eingesetzt, dass der molare Anteil an Epoxidgruppen und Säuregruppen gerade äquivalent ist. Bei der Verwendung von nur gering modifizierten Elastomeren und dem Einsatz niedermolekularer Epoxidharze mit einem niedrigen Epoxidäquivalent ergeben sich dabei nur sehr kleine Mengen an Epoxidharz, unter 10 Gew.% bezogen auf den modifizierten Nitrilkautschuk.
Das Verhältnis zwischen Säuregruppen und Epoxidgruppen kann aber in weiten Bereichen variiert werden, dabei sollte für eine ausreichende Vernetzung keine der beiden Gruppen in mehr als einem vierfachen moläquivalenten Überschuss vorliegen.

Zur Herstellung des Klebebandes werden die Bestandteile der Klebmasse in einem geeigneten Lösungsmittel, zum Beispiel Butanon, gelöst und auf ein flexibles Substrat, das mit einer Releaseschicht versehen ist, zum Beispiel einem Trennpapier oder einer Trennfolie beschichtet und getrocknet, so dass die Masse von dem Substrat leicht wieder entfernt werden kann. Nach entsprechender Konfektionierung können Stanzlinge, Rollen oder sonstige Formkörper bei Raumtemperatur hergestellt werden. Entsprechende Formkörper werden dann vorzugsweise bei erhöhter Temperatur auf das zu verklebende Substrat, zum Beispiel Polyimid, aufgeklebt.

Es ist auch möglich, die Klebmasse direkt auf einen Polyimidträger zu beschichten. Solche Klebfolien können dann zur Abdeckung von Kupferleiterbahnen für FPCBs eingesetzt werden.

Es ist nicht erforderlich, dass die Verklebung als einstufiges Verfahren erfolgt, sondern auf eines der beiden Substrate kann zunächst das Klebeband geheftet werden, indem man in der Wärme laminiert. Beim eigentlichen Heißklebeprozess mit dem zweiten Substrat (zweite Polyimidfolie oder Kupferfolie) härtet das Harz dann ganz oder teilweise aus und die Klebstofffuge erreicht die hohe Verklebungsfestigkeit.
Die zugemischten Epoxidharze sollten vorzugsweise bei der Laminiertemperatur noch keine chemische Reaktion eingehen, sondern erst bei der Heißverklebung mit den Säure- oder Säureanhydridgruppen reagieren.

Bevorzugt vernetzt das Klebeband bei Temperaturen über 150 °C.

### Beispiele

Im Folgenden wird die Erfindung durch einige Beispiele näher beschrieben, ohne dabei die Erfindung in irgendeiner Weise zu beschränken.

### Beispiel 1

80 Gew.-Teile Nipol NX 775 (Nitrilkautschuk mit 26 Gew.-% Acrylnitril und 7 Gew.-% Säuremodifizierung der Firma Zeon) werden mit 20 Gew.-Teilen Bakelite EPR 166 (Epoxidharz mit einem Epoxidäquivalent von 184 der Firma Bakelite) in Butanon gelöst, und anschließend wird die Lösung auf ein mit einer Release-Schicht versehenem Trennpapier ausgestrichen, so dass eine Schichtdicke von 25 µm nach der Trocknung resultiert.

### Beispiel 2

Zum Beispiel 1 werden 20 Gew.-Teile Piccolyte A 125 (Polyterpenharz der Firma Hercules) zugegeben und ebenfalls in Butanon gelöst. Anschließend wird wie im Beispiel 1 beschrieben vorgegangen

### Vergleichsbeispiel 3

75 Gew.-Teile Breon N41 H80 (Nitrilkautschuk der Firma Zeon mit einem Acrylnitrilgehalt von 41 Gew.-% und einer Mooney-Viskosität ML 1+4 bei 100 °C von 72 bis 88) und 25 Gew.-Teile Bakelite EPR 166 werden wie oben beschrieben in Butanon gelöst und ausgestrichen.

### Vergleichsbeispiel 4

70 Gew.-Teile Breon werden zusammen mit 25 Gew.-Teilen EPR 166 und 5 Gew.-Teilen Dyhard 100-S (Dicyandiamid der Firma Degussa) in Butanon gelöst und anschließend ausgestrichen.

### Verklebung von FPCBs mit dem hergestellten Klebeband

Zwei FPCBs werden jeweils mit den nach den Beispielen 1 bis 4 hergestellten Klebebändern verklebt. Dazu wird das Klebeband auf die Polyimidfolie des FPCB-Laminats aus Polyimid/Kupferfolie bei 100 °C auflaminiert, wobei der Klebestreifen etwas kürzer als das zu verklebende FPCB ist, um später einen Anfasser zu haben. Anschließend wird eine zweite Polyimidfolie eines weiteren FPCBs auf das Klebeband geklebt und der ganze Verbund in einer beheizbaren Bürklepresse bei 200 °C bei einem Druck von 1,3 MPa für eine Stunde verpresst.

### Prüfmethoden

Die Eigenschaften der nach den oben genannten Beispielen hergestellten Klebstofffolien werden mit folgenden Testmethoden untersucht.

### T-Peel Test mit FPCB

Mit einer Zugprüfmaschine der Firma Zwick werden die nach dem oben beschriebenen Verfahren hergestellten Verbunde aus FPCB/Klebeband/FPCB im 180° Winkel mit einer Geschwindigkeit von 50 mm/min auseinander gezogen und die benötigte Kraft in N/cm gemessen. Die Messungen werden bei 20 °C und 50 % rel. Feuchte durchgeführt. Jeder Messwert wird dreifach bestimmt.

### Temperaturbeständigkeit

Analog zum beschriebenen T-Peel Test werden die nach dem oben beschriebenen Verfahren hergestellten FPCB-Verbunde so aufgehängt, dass einer der beiden entstandenen Anfasser oben befestigt wird, am anderen Anfasser wird ein Gewicht von 500g befestigt, so dass sich zwischen den beiden FPCBs ein Winkel von 180° ausbildet. Der statische Schältest findet bei 70 °C statt. Gemessen wird der statische Schälweg in mm/h.

### Lötbadbeständigkeit

Die nach dem oben beschriebenen Verfahren verklebten FPCB-Verbunde werden für 10 Sekunden auf ein 288 °C heißes Lötbad gelegt. Die Verklebung wird als lötbadbeständig gewertet, wenn sich keine Luftblasen bilden, welche die Polyimidfolie des FPCBs aufblähen lassen. Der Test wird als nicht bestanden gewertet, wenn bereits eine leichte Blasenbildung eintritt.

### Ergebnisse:

Zur klebtechnischen Beurteilung der obengenanten Beispiele wurde zunächst der T-Peel Test durchgeführt.

Die Ergebnisse sind Tabelle 1 zu entnehmen.

**Tabelle 1**

| | T-Peel Test [N/cm] |
|---|---|
| Beispiel 1 | 12,6 |
| Beispiel 2 | 14,3 |
| Beispiel 3 | 2,7 |
| Beispiel 4 | 10,7 |

Die Klebkraft ist bei den Mustern, die neben den säuremodifizierten Elastomeren keinen Härter mehr enthalten, größer als bei dem Muster, das unmodifizierten Nitrilkautschuk verwendet aber einen zusätzlichen Härter benötigt. Ohne Vernetzung (Beispiel 3) ist die Klebkraft nur sehr gering.

Die Temperaturbeständigkeit der Klebebänder wurde mit dem statischen Peel-Test gemessen, dessen Werte in Tabelle 2 zu finden sind.

**Tabelle 2**

| | Statischer T-Peel Test bei 70 °C [mm/h] |
|---|---|
| Beispiel 1 | 5 |
| Beispiel 2 | 7 |
| Beispiel 3 | >50 |
| Beispiel 4 | 16 |

Wie zu erkennen ist, ist bei den Referenzmustern die Temperaturbeständigkeit geringer als bei den Beispielen 1 und 2.

Der Lötbadtest wurde von allen 4 Beispielen bestanden.

## Patentansprüche

1. Hitzeaktivierbares Klebeband für die Herstellung und Weiterverarbeitung von flexiblen Leiterbahnen mit einer Klebmasse bestehend aus zumindest
a. einem säure- oder säureanhydridmodifizierten Acrylnitril-Butadien-Copolymer und
b. einem Epoxidharz,
wobei das Gewichtsverhältnis der beiden Komponenten a/b größer als 1,5 ist und wobei kein zusätzlicher nicht polymerer Härter eingesetzt wird.

2. Hitzeaktivierbares Klebeband nach Anspruch 1, **dadurch gekennzeichnet, dass** der Nitrilkautschuk zumindest teilweise hydriert ist.

3. Hitzeaktivierbares Klebeband nach Anspruch 1 oder 2, **dadurch gekennzeichnet, dass** der Acrylnitrilgehalt in dem Acrylnitril-Butadienkautschuk 15 bis 50 Gew.% beträgt.

4. Hitzeaktivierbares Klebeband nach zumindest einem der vorigen Ansprüche 1 bis 3, **dadurch gekennzeichnet, dass** das Klebeband mehr als ein Epoxidharz enthält.

5. Hitzeaktivierbares Klebeband nach zumindest einem der vorigen Ansprüche, **dadurch gekennzeichnet, dass** das Klebeband klebrigmachende Harze Beschleuniger, Farbstoffe, Ruß und/oder Metallpulver enthält.

6. Hitzeaktivierbares Klebeband nach einem der vorigen Ansprüche, **dadurch gekennzeichnet, dass** das Klebeband bei Temperaturen über 150 °C vernetzt.

7. Hitzeaktivierbares Klebeband nach einem der vorigen Ansprüche, **dadurch gekennzeichnet, dass** das Klebeband noch weitere Elastomere enthält.

8. Verwendung eines hitzeaktivierbaren Klebebands gemäß zumindest einem der vorherigen Ansprüche zur Verklebung von flexiblen gedruckten Leiterbahnen.

9. Verwendung eines hitzeaktivierbaren Klebebands gemäß zumindest einem der vorherigen Ansprüche zur Verklebung auf Polyimid.

## Claims

1. Heat-activable adhesive tape for producing and further processing flexible conductor tracks, with an adhesive composed at least of
a. an acid- or acid anhydride-modified acrylonitrile-butadiene copolymer, and
b. an epoxy resin,
the weight ratio of the two components a/b being greater than 1.5 and no additional nonpolymer hardener being used.

2. Heat-activable adhesive tape of Claim 1, **characterized in that** the nitrile rubber is at least partly hydrogenated.

3. Heat-activable adhesive tape of Claim 1 or 2, **characterized in that** the acrylonitrile content of the acrylonitrile-butadiene rubber is 15% to 50% by weight.

4. Heat-activable adhesive tape of at least one of the preceding Claims 1 to 3, **characterized in that** the adhesive tape comprises more than one epoxy resin.

5. Heat-activable adhesive tape of at least one of the preceding claims, **characterized in that** the adhesive tape comprises tackifying resins, accelerators, dyes, carbon black and/or metal powders.

6. Heat-activable adhesive tape of one of the preceding claims, **characterized in that** the adhesive tape crosslinks at temperatures above 150°C.

7. Heat-activable adhesive tape of one of the preceding claims, **characterized in that** the adhesive tape further comprises additional elastomers.

8. Use of a heat-activable adhesive tape of at least one of the preceding claims for bonding flexible printed conductor tracks.

9. Use of a heat-activable adhesive tape of at least one of the preceding claims for bonding to polyimide.

## Revendications

1. Bande adhésive activable à la chaleur pour la production et la transformation ultérieure de pistes conductrices flexibles à l'aide d'une matière adhésive constituée d'au moins
a. un copolymère acrylonitrile/butadiène modifié par acide ou anhydride d'acide, et
b. une résine époxy,
où le rapport pondéral entre les deux composants a/b est supérieur à 1,5 et où on n'utilise aucun agent de durcissement non polymère supplémentaire.

2. Bande adhésive activable à la chaleur selon la revendication 1, **caractérisée en ce que** le caoutchouc nitrile est au moins partiellement hydrogéné.

3. Bande adhésive activable à la chaleur selon la revendication 1 ou 2, **caractérisée en ce que** la teneur en acrylonitrile dans le caoutchouc acrylonitrile/butadiène est de 15 à 50 % en poids.

4. Bande adhésive activable à la chaleur selon au moins l'une des revendications précédentes 1 à 3,
**caractérisée en ce que** la bande adhésive contient plus d'une résine époxy.

5. Bande adhésive activable à la chaleur selon au moins l'une des revendications précédentes, **caractérisée en ce que** la bande adhésive contient des résines collantes, des accélérateurs, des colorants, du noir de carbone et/ou de la poudre métallique.

6. Bande adhésive activable à la chaleur selon l'une quelconque des revendications précédentes, **caractérisée en ce que** la bande adhésive réticule à des températures supérieures à 150°C.

7. Bande adhésive activable à la chaleur selon l'une quelconque des revendications précédentes, **caractérisée en ce que** la bande adhésive contient également des élastomères supplémentaires.

8. Utilisation d'une bande adhésive activable à la chaleur selon au moins l'une des revendications précédentes pour le collage de pistes conductrices imprimées flexibles.

9. Utilisation d'une bande adhésive activable à la chaleur selon au moins l'une des revendications précédentes pour le collage sur du polyimide.
